## Europäisches Patentamt
## European Patent Office
## Office européen des brevets

(19)

(11) Numéro de publication: **0 109 316 B1**

(12) **FASCICULE DE BREVET EUROPEEN**

(45) Date de publication du fascicule du brevet:
**05.08.87**

(51) Int. Cl.⁴: **G 01 R 29/24,** H 03 F 3/72, H 04 N 3/15

(21) Numéro de dépôt: **83401895.4**

(22) Date de dépôt: **27.09.83**

(54) Circuit d'amplification et de mesure de charge électrique par impulsions.

(30) Priorité: **15.11.82 FR 8219097**

(43) Date de publication de la demande:
**23.05.84 Bulletin 84/21**

(45) Mention de la délivrance du brevet:
**05.08.87 Bulletin 87/32**

(84) Etats contractants désignés:
**CH DE GB IT LI SE**

(56) Documents cités:
**EP - A - 0 022 323**
**FR - A - 2 434 397**
**US - A - 3 590 153**
**US - A - 4 081 793**
**US - A - 4 298 843**
**US - A - 4 323 798**

(73) Titulaire: **INRIA INSTITUT NATIONAL DE RECHERCHE EN INFORMATIQUE ET EN AUTOMATIQUE, Domaine de Voluceau, Rocquencourt F-78150 Le Chesnay (FR)**

(72) Inventeur: **Kryze, Georges, 4, square Paul Eluard, F-78760 Pontchartrain (FR)**

(74) Mandataire: **Plaçais, Jean-Yves et al, Cabinet Netter 40, rue Vignon, F-75009 Paris (FR)**

## Description

L'invention a pour objet, selon la revendication 1, un circuit d'amplification et de mesure de charges électriques par impulsions, notamment de petites charges électriques présentes en succession rapide dans le temps, comme il se produit sous l'effet de radiations, de particules ionisantes, ou par voie piézo-électrique. l'invention a également pour objet une caméra à capteur à réseau de photodiodes selon la revendication 12.

D'une manière classique, une charge électrique est mesurée, non pas directement, mais par la tension électrique que développe ladite charge, ou une fraction déterminée de cette charge, sur une capacité connue.

Par un tel mode de mesure, il est difficile de mesurer des charges électriques se succédant rapidement dans le temps, par exemple des charges fournies par des capteurs cellulaires comprenant un réseau de photodiodes commutées soit à l'aide de transistors, soit par l'effet de transfert de charges, soit à l'aide d'un faisceau électronique, etc.

Jusqu'ici, on charge une capacité de mesure le plus parfaitement possible par la totalité de la charge à mesurer, ou par une fraction connue de celle-ci, puis, après la mesure de tension électrique correspondante, on décharge le plus parfaitement possible ladite capacité pour qu'elle soit prête à recevoir la charge suivante à mesurer, ou une fraction de cette charge.

La capacité de mesure est habituellement formée ou bien par la capacité de sortie d'un ensemble de capteurs et/ou la capacité de l'entrée du circuit de mesure, ou bien par la capacité d'intégration d'un intégrateur électronique.

Dans tous les cas, l'alternance charge/décharge de la capacité est un facteur limitant la cadence des mesures.

Si on utilise la méthode de l'intégration, en outre, on est obligé d'effectuer la décharge de la capacité d'intégration par un court-circuit entre les bornes de celle-ci, ce qui modifie grandement les paramètres de la boucle de rétroaction que comprend l'intégrateur et compromet ainsi sa stabilité. Si on cherche à y remédier, on doit augmenter le temps d'établissement, ce qui entraîne une limitation complémentaire de la cadence de mesure. Conformément à la revendication 1, l'invention a pour objet un circuit d'amplification et de mesure de charge électrique par impulsions, comprenant:

– une borne d'entrée;
– un amplificateur à haute impédance d'entrée, dont l'entrée inverseuse est reliée à ladite borne d'entrée; et
– un circuit de contre-réaction comprenant deux interrupteurs et un organe de stockage de charge;
caractérisé en ce que:

– l'amplificateur est agencé en intégrateur;
– le circuit de contre-réaction comprend, en série de la sortie de l'entrée inverseuse de l'amplificateur, au moins une branche à deux interrupteurs séparés par une liaison vers l'organe de stockage de charge, dont l'autre pôle est relié à une tension de référence, telle que la masse, la ou les branches étant suivies d'un montage propre à appliquer à l'entrée inverseuse de l'amplificateur une fraction prédéterminée de la charge stockée dans ledit organe, lors de la fermeture du second interrupteur, ceci constituant la seule voie de contre-réaction avec composante continue de l'amplificateur-intégrateur;
– les second et premier interrupteurs étant fermés en séquence et en exclusion mutuelle, à réception d'une impulsion de charge sur la borne d'entrée, et
– ladite fraction prédéterminée étant choisie de manière que la charge qui recircule par ladite voie de contre-réaction avec composante continue lors de la fermeture du second interrupteur compense la charge d'entrée qui lui a donné naissance.

Un dispositif conforme par sa structure au préambule de la revendication 1 est connu par US-A 4 323 798. Mais l'amplificateur n'est pas agencé en intégrateur, et le dispositif ne peut servir à l'amplification et à la mesure de charges électriques.

L'invention propose de remplacer la remise à zéro de la capacité de mesure avant chaque mesure par la déduction de la charge mesurée précédemment.

Cette déduction peut être simultanée à la mesure. A cet égard, l'invention prévoit la mémorisation de chaque charge mesurée jusqu'à la mesure de la charge suivante.

La boucle de rétroaction de l'intégrateur électronique peut alors être formée exclusivement de composants passifs et d'interrupteurs (transistors à effet de champ, par exemple) en nombre au moins égal à deux.

Dans un tel cas, elle comprend un seul amplificateur opérationnel, à savoir celui de l'intégrateur.

La variable dominante de la boucle de rétroaction étant effectivement la charge électrique à mesurer et non le courant, ni la tension, ni le temps, le fonctionnement de la boucle est indépendant de la cadence des mesures, laquelle peut même varier de façon aléatoire d'une mesure à l'autre.

Les variations de gain de la boucle de rétroaction dans l'intégrateur, au cours de phases de fonctionnement, sont négligeables et les paramètres de cette boucle peuvent alors être optimisés pour obtenir un temps d'établissement de la charge très court.

Le fonctionnement est insensible aux facteurs température, fréquence, variations de gain, etc.

Dans la description qui suit, faite à titre d'exemple, on se réfère aux dessins annexés, dans lesquels:

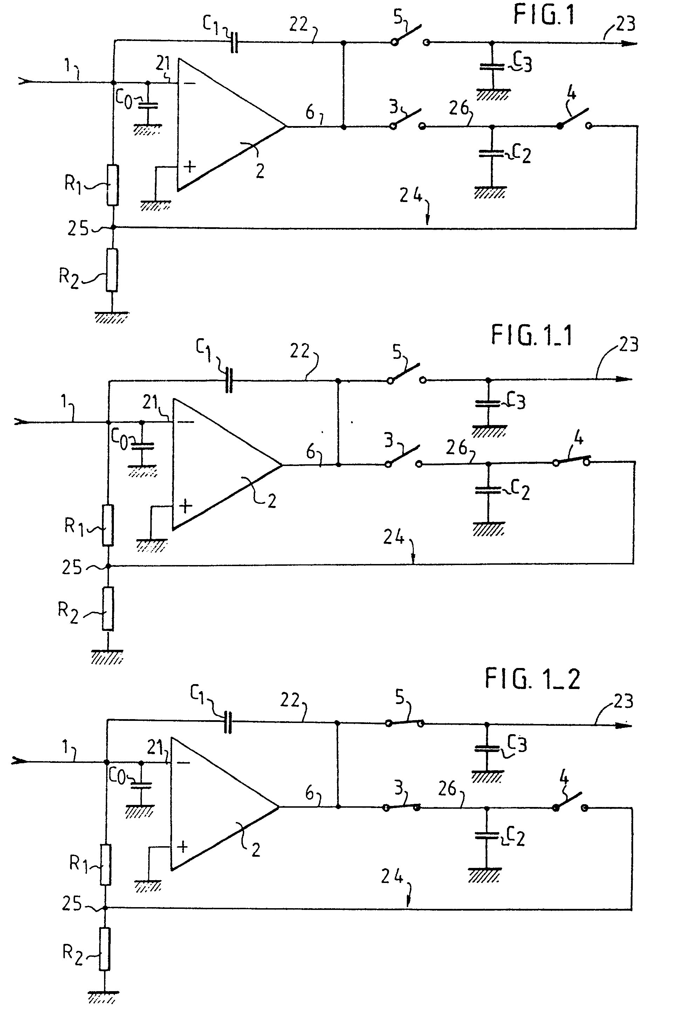

La fig. 1 est un schéma d'un appareil, pour une première forme de réalisation.

La fig. 1-1 est un schéma analogue dans un certain état des interrupteurs.

La fig. 1-2 est une vue analogue à la fig. 1-1, mais pour un autre état.

La fig. 2 est un schéma d'une seconde forme de réalisation.

La fig. 2-1 est un schéma de l'appareil montré sur la fig. 2, pour un certain état des interrupteurs.

La fig. 2-2 est une vue analogue à la fig. 2-1, mais pour un autre état.

La fig. 3 est une vue analogue à la fig. 1, mais pour une variante.

La fig. 4 est un schéma d'un différenciateur comprenant un appareil selon les fig. 1 à 3.

Une première forme de réalisation d'un appareil pour la mesure de charges électriques selon l'invention est montrée sur la fig. 1. L'entrée 1 du circuit est reliée à l'entrée 21 d'un amplificateur opérationnel 2 à gain presqu'infini, dont la boucle de rétroaction, passant par la sortie 6 de l'amplificateur 2 et par son entrée 1, comprend une branche 22 à capacité d'intégration $C_1$. La sortie 6 est reliée par un circuit 24, comprenant deux interrupteurs 3 et 4 montés en série, au point commun 25 de deux résistances $R_1$ et $R_2$ dont les autres extrémités sont reliées respectivement à l'entrée négative et à la masse. La partie 26 de ce circuit entre les interrupteurs 3 et 4 est reliée à la masse par l'intermédiaire d'une capacité $C_2$. La sortie 6 de l'amplificateur opérationnel 2 est en outre reliée à la sortie de l'appareil par un circuit 23 sur lequel est interposé un interrupteur 5 dont la fermeture met en communication la capacité $C_1$ avec l'armature d'une capacité $C_3$ dont l'autre armature est à la masse. La capacité $C_o$ à l'entrée de l'appareil symbolise la capacité de sortie du capteur relié à l'entrée 1 et la capacité d'entrée de l'amplificateur opérationnel 2.

Dans un premier temps (fig. 1.1), les interrupteurs 3 et 5 sont ouverts et l'interrupteur 4 fermé. Les charges initiales des capacités sont nulles. Lorsqu'à l'entrée 1, qui, selon les lois connues de fonctionnement d'un intégrateur électonique, a les qualités d'une masse virtuellle arrive une charge électrique $Q_i$, ladite charge, par application des mêmes lois, se trouve concentrée dans la capacité $C_1$.

Après l'arrivée de la totalité de la charge $Q_i$, la tension $U_i$ à la sortie 6 de l'amplificateur 1 est:

$$U_i = -\frac{Q_i}{C_1} \qquad (1)$$

Dans un second temps (fig. 1.2.), les interrupteurs 3 et 5 se ferment et l'interrupteur 4 s'ouvre. La tension $U_i$ est alors transférée sur la capacité $C_3$ et sur la capacité $C_2$. La concentration de la charge $Q_i$ dans la capacité $C_1$ peut toutefois continuer.

La capacité $C_2$ enferme alors une charge électrique $Q_{2i}$ dont la valeur est:

$$Q_{2i} = -Q_i . C_2/C_1 \qquad (2)$$

Dans un troisième temps, les interrupteurs 3 et 5 s'ouvrent à nouveau et l'interrupteur 4 se ferme et on retrouve la condition de la fig. 1.1.

La tension sur la capacité $C_3$ reste alors égale à la tension $U_i$, qui représente la mesure de $Q_i$ mémorisée dans la capacité $C_3$, qui est ainsi une capacité de mémoire. Cette tension est disponible pour d'éventuels traitements supplémentaires par des appareils reliés à la sortie 23 (amplification, conversion, etc.).

La capacité $C_2$ se décharge à travers les résistances $R_2$ et $R_1$, la charge se divisant dans le rapport des deux résistances.

La fraction de la charge qui revient à l'entrée 21, la capacité $C_2$ jouant ainsi le rôle de capacité de rétroaction impulsionnelle, est:

$$Q_{2i} \cdot \frac{R_2}{R_1 + R_2} \qquad (3)$$

c'est-à-dire, en tenant compte de (2)

$$-Q_i \cdot \frac{C_2 R_2}{C_1 (R_1 + R_2)} \qquad (4)$$

Cette charge s'ajoute à la charge déjà existante en $C_1$ en donnant la charge résultante:

$$Q_i \cdot \left(1 - \frac{C_2 R_2}{C_1 (R_1 + R_2)}\right) \qquad (5)$$

Les valeurs de $C_1$, $C_2$, $R_1$, $R_2$ sont choisies pour satisfaire la formule:

$$\frac{C_2 R_2}{C_1 (R_1 + R_2)} = 1 \qquad (6)$$

Avec ces valeurs, la charge provenant de la capacité $C_2$ est égale à la charge de la capacité $C_1$ et de signe contraire à celle-ci, de sorte que ladite capacité est déchargée complètement.

On peut, dès le début du troisième temps, admettre à l'entrée 1 la charge suivante à mesurer, c'est-à-dire $Q_{i+1}$. La charge sur la capacité $C_1$, dès la fin du troisième temps, sera alors dépendante seulement de cette dernière charge et ne sera pas influencée par la charge précédente $Q_1$, le processus décrit dans ce qui précède ayant permis d'enlever complètement la charge $Q_i$ de la capacité $C_1$ pendant le troisième temps.

On choisit avantageusement des résistances $R_1$ et $R_2$ ayant le même coefficient thermique, et également des capacités $C_1$ et $C_2$ ayant le même coefficient thermique. Ces quatre composants sont en outre choisis pour présenter une bonne stabilité dans le temps.

La technologie actuelle fournit des composants satisfaisant ces conditions avec une précision élevée et qui sont cependant d'un prix modéré.

L'équation de base (6) ne fait pas intervenir le temps. Le fonctionnement du circuit est donc insensible aux durées d'ouverture et de fermeture des interrupteurs, sous la seule condition que celles-ci soient suffisantes pour l'amortissement des processus transitoires engendrés par ces ouvertures et fermetures.

Il est cependant requis que les fermetures des interrupteurs 3 et 4 ne soient pas simultanées.

L'influence de la capacité $C_o$, constituée principalement par la capacité de sortie du capteur et la capacité d'entrée de l'amplificateur opérationnel, est aussi nulle: l'instabilité éventuelle de ces dernières est donc sans conséquence.

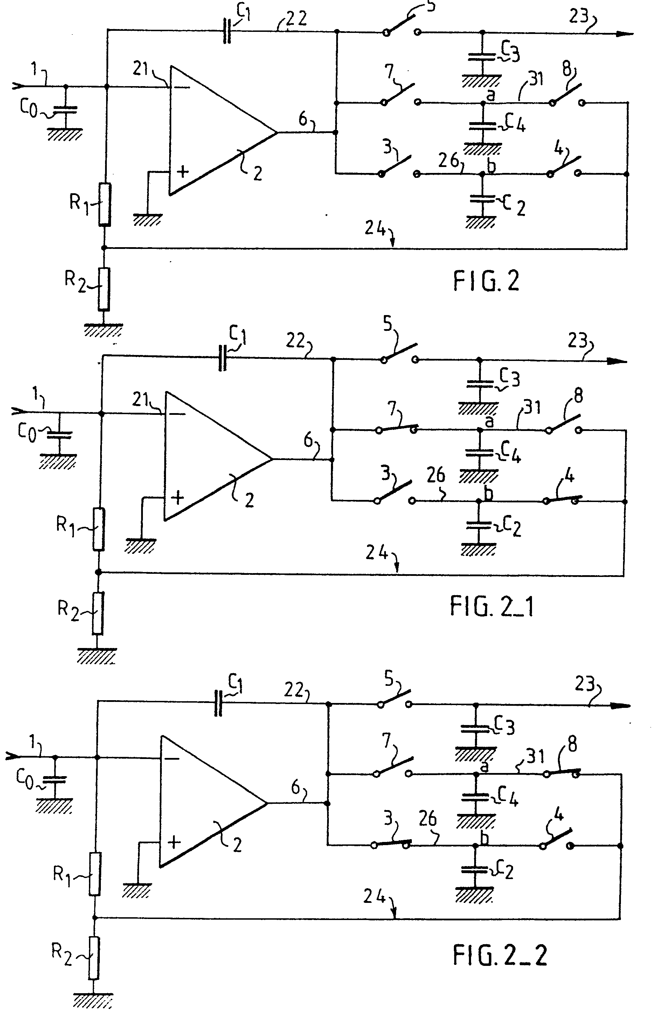

On se réfère maintentant à la fig. 2, visant une seconde forme de réalisation. Celle-ci est analogue à la première forme de réalisation, mais le circuit 24, outre la branche 26, comprend, en parallèle, une branche 31 comprenant deux interrupteurs 7 et 8 et une capacité $C_4$, équivalents respectivement des interrupteurs 3 et 4 et de la capacité $C_2$ de la branche 26.

Dans un premier temps, les interrupteurs 3 et 8 sont ouverts et les interrupteurs 4 et 7 sont fermés, l'interrupteur 5 est ouvert. L'état est celui montré su la figure 2.1. Quand à l'entrée 1 arrive la charge $Q_i$, il se déduit de cette charge la charge de la capacité $C_2$ provenant du temps précédent, et cela en analogie de ce qui a été décrit ci-dessus en référence aux fig. 1. L'influence de la charge résultant de la mesure précédente est ainsi éliminée. La mesure de la charge $Q_i$ est ainsi effectuée sans qu'elle ait été influencée par les mesures antérieures.

Dans un deuxième temps, les interrupteurs 3 et 8 se ferment et les interrupteurs 4 et 7 s'ouvrent: c'est la condition montrée sur la fig. 2.2. La charge $Q_{i+1}$ arrive sur l'entrée 1 et, de la même façon qu'à l'état précédent, la charge de la capacité $C_4$, mise en mémoire dans la condition précédente, se déduit à l'entrée 1, de sorte que l'influence de la charge antérieure $Q_i$ est éliminée.

Comme dans la réalisation précédente, la condition suivante est remplie par les résistances $R_1$ et $R_2$ et la capacité $C_2$:

$$\frac{C_2 R_2}{C_2 (R_1 + R_2)} = 1 \qquad (7)$$

En outre, la condition ci-après est remplie:

$$C_2 = C_4 \qquad (8)$$

L'interrupteur 5 est fermé pendant un bref intervalle, juste avant chaque commutation entre eux des deux couples des autres interrupteurs, à savoir respectivement 3 et 8, et 4 et 7.

Dans cette forme de réalisation, on mesure une charge électrique pour chaque commutation, ce qui permet de doubler la cadence maximale des mesures par rapport à celle de la réalisation selon la fig. 1 pour un amplificateur de même qualité.

Dans les deux réalisations précédentes, c'est l'interrupteur 5 et la capacité $C_3$ qui procurent l'échantillonnage et le blocage de la charge électrique en cours de mesure.

Dans une variante, la sortie 6 de l'amplificateur opérationnel 2 est reliée directement à l'entrée d'un amplificateur, ou d'un convertisseur, ou d'un différenciateur.

L'invention prévoit des réalisations destinées à tenir compte des processus transitoires, des caractéristiques de stabilité de l'intégrateur, de la présence de capacités, inductances ou résistances distribuées ou parasites.

Ces réalisations comprennent, à la place de simples résistances ou capacités, des impédances générales ou même des quadripôles généraux.

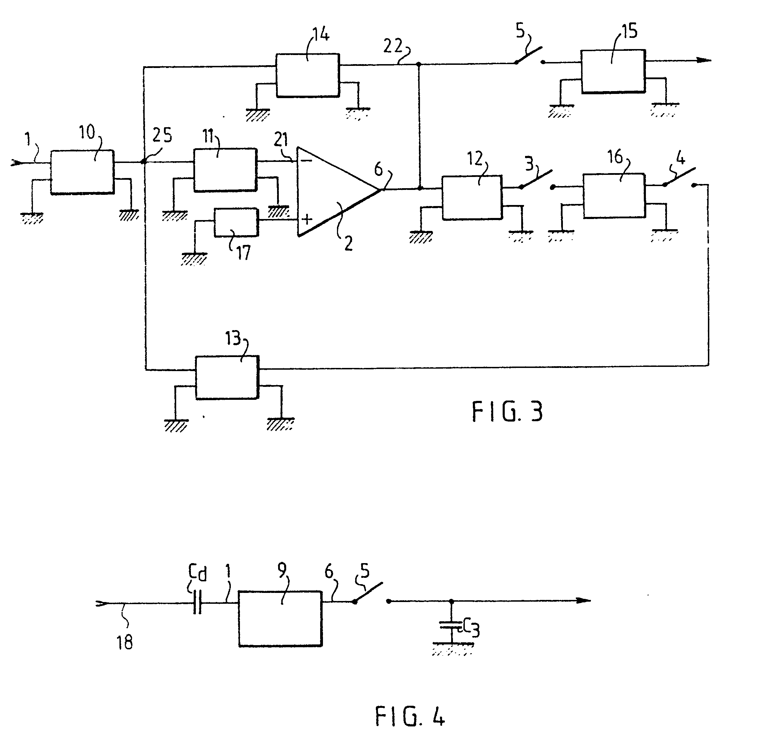

Un exemple d'une telle réalisation est représenté sur la fig. 3 et a la même organisation générale que celle représentée sur la fig. 1. La capacité $C_o$ de la fig. 1, qui symbolisait la capacité de sortie du capteur et la capacité d'entrée de l'amplificateur opérationnel, est ici remplacée par un premier quadripôle 10 entre l'entrée de l'appareil et le point commun 25 des deux branches de la boucle de rétroaction et par un second quadripôle 11 entre le point 25 et l'entrée 21 de l'amplificateur opérationnel 2. La capacité $C_1$ de la branche 22 de la boucle de la fig. 1 est ici remplacée par un quadripôle 14 et la capacité $C_3$ de blocage et d'échantillonnage est remplacée par un quadripôle 15. La capacité $C_2$ est remplacée par un quadripôle 16 disposé entre les interrupteurs 3 et 4. Dans le circuit comprenant l'interrupteur 3, et reliant le quadripôle 16 au quadripôle général 14, est interposé un quadripôle 12. Le répartiteur constitué par les résistances $R_1$ et $R_2$ est remplacé par le quadripôle général 13. L'entrée positive de l'amplificateur opérationnel 2 est mise à la masse par l'intermédiaire d'une impédance générale 17.

Des transformateurs et/ou des éléments non linéaires ou actifs peuvent faire partie de ces quadripôles et impédances.

Dans une réalisation, la fonction jouée par les résistances $R_1$ et $R_2$ de la forme de réalisation montrée sur la fig. 1, à savoir la distribution de la charge électrique contenue dans la capacité $C_2$, est remplie par un transformateur, auquel sont éventuellement adjoints des diodes et autres éléments.

Des modifications analogues s'appliquent à la réalisation montrée sur la fig. 2.

Avantageusement, les circuits des fig. 1 à 3 peuvent être réalisés avec des composants ajustables, comme des potentiomètres ou des condensateurs, ce qui permet d'ajuster chaque composant à la valeur exacte exigée pour le bon fonctionnement.

Dans une variante, l'intégrateur ou amplificateur opérationnel est supprimé et remplacé par un amplificateur à gain fini en tension égal à A. La capacité $C_1$ est alors supprimée ainsi que la résistance $R_2$. L'accumulation de la charge se fait dans la capacité $C_o$, formée le plus souvent par la capacité de sortie du capteur fournissant la charge et la capacité d'entrée de l'amplificateur à gain en tension, éventuellement grâce à un condensateur supplémentaire.

L'équation d'équilibre des charges est alors:

$$(A-1).\, C_2 = C_o \qquad (9)$$

La tension de mesure à la sortie de l'amplificateur est alors:

$$U_i = \frac{A \cdot Q_i}{C_o + C_2} \qquad (10)$$

On prévoit une variante analogue pour la forme de réalisation représentée sur la fig. 2.

Des interrupteurs supplémentaires peuvent être ajoutés, pour améliorer la séparation, ou modifier le fonctionnement.

Par exemple, on peut doubler les interrupteurs existants pour supprimer les courants de fuite.

On peut aussi remplacer un couple d'interrupteurs, comme 3 et 4 ou 7 et 8, par un inverseur.

L'invention prévoit que les interrupteurs de l'appareil sont avantageusement constitués par des transistors à effet de champ. Dans des cas spéciaux, on peut aussi envisager l'utilisation de transistors bipolaires ou de contacts à comande optique, magnétique ou électromécanique.

L'invention comprend dans son cadre un appareil pour la mesure de différences de charges électriques qui fait utilisation d'un appareil de mesure de charges comme montré sur l'une des fig. 1 à 3.

Un tel différenciateur fait application de la constation suivant laquelle la totalité d'une charge électrique transitant par une capacité entre deux instants donnés est déterminée par la différence des tensions sur celle-ci existant à ces deux instants.

Dans la forme de réalisation montrée sur la fig, 4, on a représenté en 9 un des appareils comme selon la fig. 1 ou la fig. 2 ou la fig. 3, avec son entrée 1 et sa sortie 6. L'échantillonneur est composé de la capacité $C_3$, reliée à la sortie 6 par l'intermédaire de l'interrupteur 5.

La tension à l'entrée 18 du différenciateur est $\hat{U}_i$. Elle est reliée à l'entrée 1 du circuit 9 à travers une capacité de différenciation $C_d$.

La charge $Q_i$ mesurée entre deux prises d'échantillon sur l'appareil 9 avec intégrateur est:

$$Q_2 = (\hat{U}_i - \hat{U}_{i-1}) C_d \qquad (11)$$

dans laquelle $\hat{U}_i$ et $\hat{U}_{i-1}$ jsont les valeurs des tensions à l'entrée 18 à ces instants d'échantillonnage, et qui correspondent à des instants de commutation des interrupteurs du circuit 9.

A ces mêmes instants, la tension à la sortie 6 du circuit 9 est:

$$U_i = -(\hat{U}_i - \hat{U}_{i-1}) \frac{C_d}{C_1} \qquad (12)$$

soit la différence des tensions $\hat{U}_i$.

L'absence du facteur temps dans les relations aboutissant à la différence des tensions qui est à mesurer confère au différenciateur une stabilité de fonctionnement remarquable.

Selon une réalisation, de petites résistances sont montées en série avec la capacité $C_d$, qui contrôlent la décharge de celle-ci et préservent la stabilité de l'amplificateur opérationnel faisant partie du différenciateur.

Les amplificateurs utilisés dans les diverses réalisations décrites sont à très haute impédance d'entrée, par exemple des amplificateurs dont les étages d'entrée mettent en œuvre des transistors à effet de champ.

Les circuits selon les fig. 1 à 4 peuvent fonctionner avec des valeurs $C_1$, $C_2$, $R_1$, $R_2$ qui ne satisfont pas l'équation (6).

Si on désigne pr $\alpha$ la valeur de l'expression de la partie gauche de la formule (6):

$$\frac{C_2 R_2}{C_1 (R_1 + R_2)} = \alpha \qquad (13)$$

alors le fonctionnement du circuit sera régi par l'équation à différences:

$$U_i + (\alpha - I) U_{i-I} = -\frac{Q_i}{C_1} \qquad (14)$$

dont la solution

$$U_i = -\frac{1}{C_1} \sum_{k=o}^{\infty} Q_{i-k}(I-\alpha)^k \qquad (15)$$

montre que $U_i$ va dépendre de toutes les charges précédentes.

Ceci donne la possibilité, avec $\alpha < 1$, d'effectuer un certain lissage, ou, avec $\alpha > 1$, d'accentuer les transitions de la séquence des $Q_i$.

Un appareil selon l'invention s'applique avantageusement en relation avec des caméras à réseau linéaire ou matriciel de photodiodes à commutation et également à transfert de charge. Il rend possible une augmentation substantielle de la cadence de lecture conjointement avec une excellente stabilité et une excellente séparation des échantillons.

**Revendications**

1. Circuit d'amplification et de mesure de charge électrique par impulsions, comprenant:
   – une borne d'entrée (1);
   – Un amplificateur (2) à haute impédance d'entrée, dont l'entrée inverseuse est reliée à ladite borne d'entrée; et
   – un circuit de contre-réaction (24) comprenant deux interrupteurs (3, 4) et un organe de stockage de charge ($C_2$);
   caractérisé en ce que:
   – l'amplificateur (2) est agencé en intégrateur;
   – le circuit de contre-réaction (24) comprend, en série de la sortie à l'entrée inverseuse de l'amplificateur, au moins une branche à deux interrupteurs (3, 4) séparés par une liaison vers l'organe de stockage de charge ($C_2$), dont l'autre pôle est relié à une tension de référence, telle que la masse, la ou les branches étant suivies d'un montage (25, $R_1$, $R_2$) propre à appliquer à l'entrée inverseuse de l'amplificateur (2) une fraction prédéterminée de la charge stockée dans ledit organe ($C_2$), lors de la fermeture du second interrupteur (4), ceci constituant la seule voie de contre-

réaction avec composante continue de l'amplificateur-intégrateur;

– les second (4) et premier (3) interrupteurs étant fermés en séquence et en exclusion mutuelle, à réception d'une impulsion de charge sur la réaction avec composante continue de l'amplificateur-intégrateur;

– les second (4) et premier (3) interrupteurs étant fermés en séquence et en exclusion mutuelle, à réception d'une impulsion de charge sur la borne d'entrée, et

– ladite fraction prédéterminée étant choisie de manière que la charge qui recircule par ladite voie de contreréaction avec composante continue lors de la fermeture du second interrupteur (4) compense la charge d'entrée qui lui a donné naissance.

2. Circuit selon la revendication 1, caractérisé en ce que la voie de contre-réaction avec composante continue comprend deux branches (26, 31) en parallèle entre la sortie de l'amplificateur et ledit montage ($R_1$, $R_2$), les premier (3) et second (4) interrupteurs de la première branche (26) étant fermés en opposition avec ceux (7, 8) de la seconde branche (8).

3. Circuit selon l'une des revendications 1 et 2, caractérisé en ce que l'organe de stockage de charge comprend un condensateur ($C_2$).

4. Circuit selon l'une des revendications précédentes, caractérisé en ce que l'amplificateur à haute impédance d'entrée est un amplificateur opérationnel à très haut gain comportant une branche de rétroaction (22) essentiellement capacitive susceptible de réaliser la fonction d'intégration.

5. Circuit selon l'une des revendications précédentes, caractérisé en ce que ledit montage comprend un quadripôle (13) comportant des éléments choisis parmi les résistances, condensateurs, inductances et transformateurs.

6. Circuit selon la revendication 4, caractérisé en ce que l'amplificateur opérationnel (2) a une entrée non inverseuse reliée à ladite tension de référence.

7. Circuit selon l'une des revendications précédentes, caractérisé en ce que la tension de référence est la terre.

8. Circuit selon l'une des revendications précédentes, caractérisé en ce que la borne d'entrée (1) a un comportement d'impédance parallèle essentiellement capacitive.

9. Circuit selon l'une des revendications précédentes, caractérisé en ce que l'organe de stockage de charge comprend une combinaison d'éléments passifs et actifs.

10. Circuit selon l'une des revendications précédentes, caractérisé en ce qu'il comprend en outre un élément essentiellement capacitif ($C_d$) en série entre la borne d'entrée (18) et l'entrée inverseuse de l'amplificateur, et fonctionne ainsi en différentiateur.

11. Circuit selon l'une des revendications précédentes, caractérisé en ce qu'il comprend un troisième interrupteur (5) branché entre la sortie de l'amplificateur et un condensateur de sortie ($C_3$) pour échantillonner et mémoriser la charge reçu par l'amplificateur intégrateur avant la fermeture du second interrupteur.

12. Caméra à capteur à réseau de photodiodes, caractérisée en ce que la charge développée sur les diodes du réseau par le rayonnement capté est évaluée à l'aide de l'un des circuits selon les revendications précédentes.

**Patentansprüche**

1. Schaltung zum Verstärken und Messen von elektrischen Ladungen durch Impulse mit:
– einer Eingangsklemme (1)
– einem Verstärker (2) mit hoher Eingangsimpedanz, dessen invertierender Eingang mit der Eingangsklemme (1) verbunden ist
– mit einem Gegenkopplungskreis(24), der zwei Unterbrecher (2, 4) und einen Ladungsspeicher ($C_2$) enthält, dadurch gekennzeichnet, dass
– der Verstärker (2) als Integrator geschaltet ist,
– der Gegenkopplungskreis (24) in Reihe vom Ausgang zum Eingang des invertierenden Verstärkers mindestens einen Zweig mit zwei Unterbrechern (3, 4) enthält, zwischen denen eine Verbindung zum Ladungsspeicher ($C_2$) abgeht, dessen anderer Pol an einer Bezugsspannung liegt, z.B. Masse, wobei sich an den Zweig oder Zweige ein Schaltungsteil (25, $R_1$, $R_2$) anschliesst, das bei geschlossenem zweiten Unterbrecher (4) auf den invertierenden Eingang des Verstärkers (2) einen vorgegebenen Anteil der im Ladungsspeicher ($C_2$) gespeicherten Ladung aufgibt und den einzigen Pfad der Gegenkopplung des integrierenden Verstärkers mit Gleichstromkomponente bildet;
– der zweite (4) und der erste Unterbrecher (3) nach Empfang eines Ladeimpulses auf der Eingangsklemme nacheinander unter Ausschluss gleichzeitigen Schliessens geschlossen werden,
– der vorgegebene Ladungsanteil derart gewählt ist, dass die beim Schliessen des zweiten Unterbrechers (4) über den Gegenkopplungspfad mit Gleichstromkomponente laufende Ladung die sie ausgelöste Eingangsladung kompensiert.

2. Schaltung nach Anspruch 1, dadurch gekennzeichnet, dass der Gegenkopplungspfad mit Gleichstromanteil zwei parallele Zweige (26, 31) zwischen dem Ausgang des Verstärkers und dem Schaltungsteil ($R_1$, $R_2$) enthält, wobei der erste (3) und der zweite (4) Unterbrecher des ersten Zweiges (26) immer in entgegengesetzter Schaltstellung zu den Unterbrechern (7, 8) des zweiten Zweiges (31) geschlossen sind.

3. Schaltung nach Anspruch 1 oder 2, dadurch gekennzeichnet, dass der Ladungsspeicher einen Kondensator ($C_2$) umfasst.

4. Schaltung nach einem der vorhergehenden Ansprüche, dadurch gekennzeichnet, dass der Verstärker mit hoher Eingangsimpedanz ein hochverstärkender Operationsverstärker (2) ist, der einen im wesentlichen kapazitiven Rückkopplungszweig (22) zur Umsetzung der Integralfunktion hat.

5. Schaltung nach einem der vorhergehenden Ansprüche, dadurch gekennzeichnet, dass der Schaltungsteil eine Vierpolschaltung (13) mit aus Widerständen, Kondensatoren, Induktanzen und Transformatoren ausgewählten Bauteilen enthält.

6. Schaltung nach Anspruch 4, dadurch gekennzeichnet, dass der Operationsverstärker (62) einen nicht invertierenden, an der Bezugsspannung liegenden Eingang hat.

7. Schaltung nach einem der vorhergehenden Ansprüche, dadurch gekennzeichnet, dass die Bezugsspannung Erde ist.

8. Schaltung nach einem der vorhergehenden Ansprüche, dadurch gekennzeichnet, dass die Eingangsklemme (1) das Verhalten einer parallelen, im wesentlichen kapazitiven Impedanz aufweist.

9. Schaltung nach einem der vorhergehenden Ansprüche, dadurch gekennzeichnet, dass der Ladungsspeicher eine Kombination aus aktiven und passiven Bauelementen aufweist.

10. Schaltung nach einem der vorhergehenden Ansprüche, gekennzeichnet durch ein weiteres, im wesentlichen kapazitives Element ($C_d$) in Reihe zwischen der Eingangsklemme (18) und dem invertierenden Eingang des Verstärkers, das differenzierend arbeitet.

11. Schaltung nach einem der vorhergehenden Ansprüche, gekennzeichnet durch einen zwischen den Ausgang des Verstärkers und einen Ausgangskondensator ($C_3$) geschalteten dritten Unterbrecher (5) zur Momentwertbildung und Speicherung der vom integrierenden Verstärker erhaltenen Ladung vor Schliessen des zweiten Unterbrechers.

12. Kamera mit einer aus Photodioden aufgebauten Messzelle, dadurch gekennzeichnet, dass die bei Einfallen der Strahlung über den Dioden anliegende Ladung mit Hilfe einer der Schaltungen der vorhergehenden Ansprüche erfasst wird.

**Claims**

1. Circuit for amplifying and measuring pulsed electrical charge, comprising:
an input terminal (1);
a high-impedance input amplifier (2), the inverting input of which is connected to the said input terminal; and
a negative feedback circuit (24) comprising two switches (3, 4) and a charge storage component ($C_2$);
characterized in that:
the amplifier (2) is arranged as an integrator; the negative feedback circuit (24) comprises, in series from the output to the inverting input of the amplifier, at least one branch with two switches (3, 4) separated by a connection to the charge storage component ($C_2$), the other pole of which is connected to a reference voltage, such as earth, the branch or branches being followed by an assembly (25, $R_1$, $R_2$) capable of applying a predetermined fraction of the charge stored in the said component ($C_2$) to the inverting input of the amplifier (2) on closing of the second switch (4), this constituting the only negative feedback path with a direct component from the integrating amplifier;
the second switch (4) and the first switch (3) being closed in sequence and in mutual exclusion in reception of a charge pulse on the input terminal, and the said predetermined fraction being selected in such a manner that the charge which recirculates by the said negative feedback path with a direct component on closing of the second switch (4) compensates the input charge which gave rise thereto.

2. Circuit according to Claim 1, characterized in that the negative feedback path with a direct component comprises two branches (26, 31) in parallel between the output of the amplifier and the said assembly ($R_1$, $R_2$), the first switch (3) and the second switch (4) of the first branch (26) being closed in opposition to those (7, 8) of the second branch (8).

3. Circuit according to one of Claims 1 and 2, characterized in that the charge storage component comprises a capacitor ($C_2$).

4. Circuit according to one of the preceding claims, characterized in that the high-impedance input amplifier is a very-high-gain operational amplifier comprising an essentially capacitive feedback branch (22) capable of executing the function of integration.

5. Circuit according to one of the preceding claims, characterized in that the said assembly comprises a quadrupole (13) comprising elements selected from resistors, capacitors, inductors and transformers.

6. Circuit according to Claim 4, characterized in that operational amplifier (2) has a non-inverting input connected to the said reference voltage.

7. Circuit according to one of the preceding claims, characterized in that the reference voltage is earth.

8. Circuit according to one of the preceding claims, characterized in that the input terminal (1) has essentially capacitive parallel impedance properties.

9. Circuit according to one of the preceding claims, characterized in that the charge storage component comprises a combination of passive and active elements.

10. Circuit according to one of the preceding claims, characterized in that it further comprises an essentially capacitive element ($C_d$) in series between the input terminal (18) and the inverting input of the amplifier, and thus operates as a differentiator.

11. Circuit according to one of the preceding claims, characterized in that it comprises a third switch (5) connected between the output of the amplifier and an output capacitor ($C_3$) to sample and to store the charge received by the integrating amplifier prior to closing of the second switch.

12. Camera inlcuding a sensor having an array of photodiodes, characterized in that the charge developed on the diodes of the array by the radiation detected is evaluated by means of one of the circuits according to the preceding claims.

FIG.1

FIG. 1_1

FIG. 1_2

FIG. 2

FIG. 2_1

FIG.2_2

FIG. 3

FIG. 4